# EUROPÄISCHE PATENTSCHRIFT

(11) **EP 3 621 422 B1**
(45) Veröffentlichungstag und Bekanntmachung des Hinweises auf die Patenterteilung: **03.05.2023**
(21) Anmeldenummer: 19191261.7
(22) Anmeldetag: 12.08.2019
(51) Int. Cl.: H05K 7/20

(54) **KÜHLVORRICHTUNG FÜR MINDESTENS EIN AUF EINER LEITERPLATTE MONTIERTES BAUELEMENT**
COOLING DEVICE FOR AT LEAST ONE COMPONENT MOUNTED ON A PRINTED CIRCUIT BOARD
DISPOSITIF DE REFROIDISSEMENT POUR AU MOINS UN COMPOSANT MONTÉ SUR UN CARTE DE CIRCUIT IMPRIMÉ

(30) Priorität: 10.09.2018 DE 102018215338
(43) Veröffentlichungstag der Anmeldung: 11.03.2020
(73) Patentinhaber: Dürkopp Adler AG, 33719 Bielefeld (DE)
(72) Erfinder: Pfeiffer, Sven, 33613 Bielefeld (DE); Bongers, Alexander, 33609 Bielefeld (DE); Lieberum, Felix, 32425 Minden (DE); Harbaum, Maurice, 33611 Bielefeld (DE)
(74) Vertreter: Rau, Schneck & Hübner Patentanwälte Rechtsanwälte PartGmbB

(56) Entgegenhaltungen:
- DE-A1- 19 506 664
- DE-A1-102010 008 074
- US-A1- 2003 067 746
- US-A1- 2015 001 701

## Beschreibung

Die Erfindung betrifft eine Kühlvorrichtung für mindestens ein auf einer Leiterplatte montiertes Bauelement. Ferner betrifft die Erfindung eine mit Bauelementen bestückte Leiterplatte mit mindestens einer derartigen Kühlvorrichtung.

Kühlvorrichtungen für Leiterplatten-Bauelemente sind als Kühlkörper mit beispielsweise über Rippenstrukturen vergrößerter Oberfläche bekannt. Derartige Kühlkörper werden innerhalb eines Leiterplattengehäuses eingesetzt. Ebenfalls bekannt ist eine Nutzung eines Gehäuses für eine Leiterplatte als Kühlkörper, in dem Bauteile mit zusätzlichem Montage- und Isolationsaufwand mit dem Kühlkörper durch beispielsweise Klammern oder Verschrauben verbunden werden. Solche Kühltechnologien erfordern oftmals einen erhöhten Montageaufwand.

Die DE 10 2010 008 074 A1 beschreibt ein Gehäuse mit einer Kühlvorrichtung. Die US 2015/0 001 701 A1 beschreibt ein Multichip-Modul mit einem Versteifungsrahmen und zugehörigen Abdeckungen. Die US 2003/0 067 746 A1 beschreibt eine Kühleinrichtung unter Verwendung eines wärmeleitenden Fluids.

Die JP 2004 006 791 A offenbart eine Steuerungsvorrichtung mit einer Leiterplatte, aufweisend ein elektronisches Bauelement mit einer Kühleinrichtung, aufweisend eine Wärmeleitungsschicht. Die DE 10 2009 005 067 A1 offenbart eine Platte zur gerichteten Wärmeabfuhr von wärmeentwickelnden Bauteilen, die beispielsweise als Deckel zum Abschluss eines Gehäuses ausgeführt sein kann und Bereiche aus verschiedenen Materialien mit verschiedenen Wärmeleitfähigkeiten aufweist. Die DE 10 2008 047 649 A1 beschreibt eine Platte als Bestandteil einer Anordnung zum Wärmeausgleich innerhalb einer Leiterplatte und zum Abführen von Wärme von einer Leiterplatte und den dort befindlichen Bauelementen.

Die DE 10 2008 033 193 A1 offenbart ein Schutzelement, ausgeführt unter anderem als thermische Brücke zwischen einer Kontaktfläche zu einem Bauelement oder zu einer Leiterplatte und einer Gehäuseinnenfläche eines Gehäuses einer Steuerungsvorrichtung. Die DE 10 2007 052 397 A1 beschreibt eine Kühlvorrichtung zur thermischen Kontaktierung zwischen einem Halbleiterchip und einem Kühlkörper mit einem Wärmespreizerelement und elastischen Wärmeleitpads. Die DE 10 2005 040 843 A1 offenbart ein Wärmeableitungsteil zwischen einem wärmeerzeugenden Bauelement und einer inneren Gehäuseoberfläche eines eine Leiterplatte aufnehmenden Gehäuses. Das Wärmeableitungsteil ist aus einem Polymermaterial mit Fließeigenschaft. Die DE 603 15 469 T2 beschreibt ein Wärmeableitsystem mit einem Wärme-Ableiteinsatz, der in einer Leiterplatte auf Höhe einer elektronischen Leistungskomponente in einer hierfür ausgebildeten Ausnehmung eingesetzt ist. Die DE 195 32 992 A1 beschreibt eine einseitig bestückte Leiterplatte, auf deren Rückseite eine Kühlplatte aufgebracht ist. Die DE 195 06 664 A1 beschreibt wärmeableitende Elemente zur Ableitung von Wärme von auf einer Leiterplatte angeordneten Leistungsbauelementen, wobei das Leistungsbauelement mit einem separaten Wärmeableitblock in thermischem Kontakt steht. Die US 2003/0 227 750 A1 beschreibt eine Wärmeabführeinrichtung zur Abfuhr von Wärme von einer elektronischen Komponente mit einem elastisch deformierbaren Teil, das mit der elektronischen Komponente in thermischem Kontakt steht. Die US 2008/0 084 672 A1 beschreibt eine elektronische Anordnung mit einem Gehäuse mit mobilen Wärmesenke-Elementen, die auf eine Gehäuseinnenwand aufgesteckt werden können.

Es ist eine Aufgabe der vorliegenden Erfindung, eine Kühlvorrichtung der eingangs genannten Art derart weiterzubilden, dass auch anspruchsvolle thermische Anforderungen zu kühlender Bauelemente erfüllt werden können.

Diese Aufgabe ist erfindungsgemäß gelöst über eine Kühlvorrichtung mit den in Anspruch 1 angegebenen Merkmalen.

Erfindungsgemäß wurde erkannt, dass die Anforderungen einerseits an eine Montierbarkeit der Kühlvorrichtungen, andererseits an deren Kühlleistung dadurch separierbar sind, dass diese Anforderungen auf verschiedene Komponenten der Kühlvorrichtung verteilt werden. Der mindestens eine Wärmeleiter liefert einen Beitrag für eine effektive Kühlung durch die Kühlvorrichtung. Die Kunststoff-Wärmeleitelementfassung ist einfach fertigbar und positioniert das Wärmeleitelement gegenüber der Leiterplatte. Bei dem Wärmeleitelement kann es sich um einen Metall-Kühlkörper handeln. Die Leiterplatten-Wärmeleitungsschicht sorgt für eine gute Wärmeübertragung zwischen dem Wärmeleitelement und dem zu kühlenden, auf der Leiterplatte montiertem Bauelement. Die Leiterplatten-Wärmeleitungsschicht kann zum Niveauausgleich zur Anpassung von Zusammenbau-Maßtoleranzen anderer Komponenten dienen. Die Leiterplatten-Wärmeleitungsschicht kann flexibel ausgeführt sein. Die Leiterplatten-Wärmeleitungsschicht kann schwingungsdämpfend ausgeführt sein. Das Wärmeleitelement kann aus Kupfer und/oder aus Keramik und/oder aus Aluminium gefertigt sein. Die Kühlvorrichtung genügt anspruchsvollen thermischen und auch elektrischen Anforderungen.

Je nach Anzahl der zu kühlenden Bauelemente kann auch eine Mehrzahl derartiger Kühlvorrichtungen pro Leiterplatte zum Einsatz kommen.

Die Kühlvorrichtung kann automatisiert gefertigt werden.

Die Kühlvorrichtung kann insbesondere rückstandsfrei demontierbar sein.

Die Kunststoff-Kühlkörperfassung kann aus einem Material gefertigt sein, welches insbesondere brandfest, elektrisch isolierend, wärmebeständig und formbeständig ist.

Die Leiterplatten-Wärmeleitungsschicht kann elektrisch isolierend ausgeführt sein.

Ein Metallgehäuse nach Anspruch 2 sorgt für eine sichere Aufnahme der Leiterplatte und für einen Schutz der Kühlvorrichtung. Das Metallgehäuse kann zudem für eine Wärmeabgabe an die Umgebung sorgen.

Eine Metallgehäuse-Wärmeleitungsschicht nach Anspruch 3 ermöglicht eine Wärmeableitung von mindestens einem Wärmeleitelement der Kühlvorrichtung hin zum Metallgehäuse, welches dann zur Kühlung beiträgt. Das Metallgehäuse kann hierzu oberflächenvergrößernde Rippenstrukturen aufweisen. Die Metallgehäuse-Wärmeleitungsschicht kann Fertigungs-Höhentoleranzen zwischen der Leiterplatte und der Gehäusewand des Metallgehäuses ausgleichen. Die Metallgehäuse-Wärmeleitungsschicht kann stärker ausgeführt sein als die Leiterplatten-Wärmeleitungsschicht.

Die Leiterplatten-Wärmeleitungsschicht kann als Dispersion aus wärmeleitfähigem Material oder auch als Folie oder als Gel ausgeführt sein. Die Metallgehäuse-Wärmeleitungsschicht kann als Dispersion aus wärmeleitfähigem Material oder auch als Folie oder als Gel ausgeführt sein.

Mindestens ein Verbindungselement nach Anspruch 4 lässt sich einfach fertigen und sorgt für eine sichere mechanische Verbindung der Kühlvorrichtung mit der Leiterplatte. Eine automatisierte Bestückung der Leiterplatte mit der Kühlvorrichtung oder den Kühlvorrichtungen ist möglich. Alternativ zu einer Anformung des Verbindungselementes an die Wärmeleitelementfassung kann das Verbindungselement an der Wärmeleitelementfassung auch in anderer Weise angebracht oder aufgebracht sein.

Eine Ausführung des mindestens einen Verbindungselements nach Anspruch 5 ist einerseits kostengünstig und andererseits sicher.

Räumlich separierte Verbindungselemente nach Anspruch 6 ermöglichen eine exakte Positionierung der Wärmeleitelementfassung relativ zur Leiterplatte, sodass eine sichere Zuordnung des jeweiligen Metall-Kühlkörpers zum zu kühlenden Bauteil gewährleistet ist. Bei Bedarf kann durch die Verbindungselemente ein elektrischer Isolierabstand vorgegeben werden.

Die Vorteile einer Leiterplatte nach Anspruch 7 entsprechen denen, die vorstehend unter Bezugnahme auf die erfindungsgemäße Kühlvorrichtung bereits erläutert wurden. Alternativ zu einer derartigen wärmeleitenden Verbindung der Leiterplatten-Wärmeleitungsschicht mit den zu kühlenden Bauelement über ein Via kann eine wärmeleitende Verbindung zwischen der Leiterplatten-Wärmeleitungsschicht und dem zu kühlenden Bauelement auch über einen Aluminiumkern, über Kupferflächen oder über Heatpipes erfolgen.

Bei dem mindestens einen zu kühlenden Bauelement kann es sich um ein SMD-Bauelement handeln.

Ausführungsbeispiele der Erfindung werden nachfolgend anhand der Zeichnung näher erläutert. In dieser zeigen:

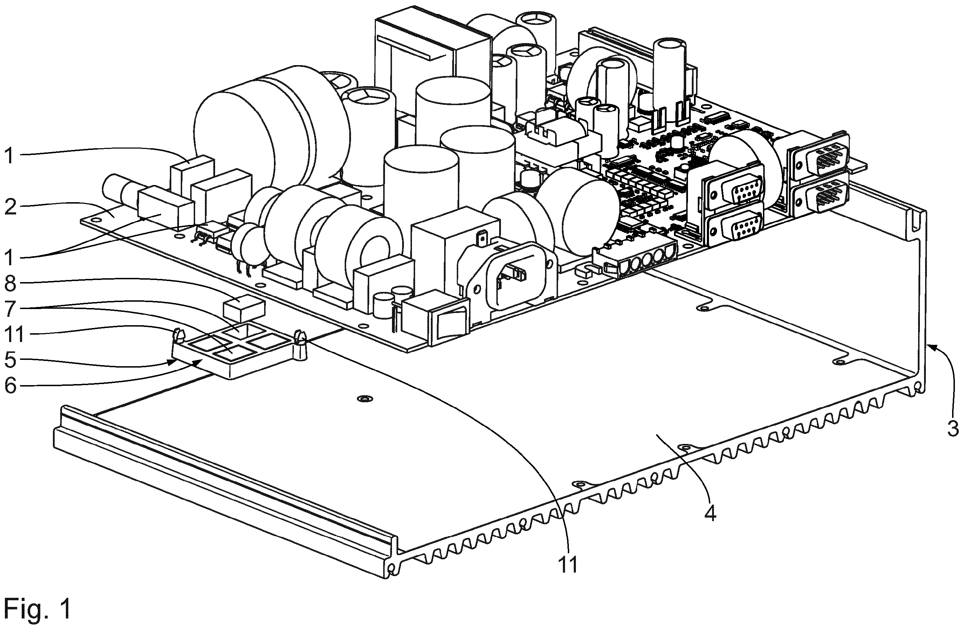

- Fig. 1: in einer Explosionsdarstellung eine mit Bauelementen bestückte Leiterplatte, ein Metallgehäuse zur Aufnahme der Leiterplatte und eine für vier Metall-Kühlkörper vorgesehene Kunststoff-Kühlkörper-fassung einer Kühlvorrichtung für mindestens ein auf der Leiterplatte montiertes Bauelement, angeordnet zwischen der Leiterplatte und einer Gehäusewand des Metallgehäuses, wobei lediglich einer der in eine Aufnahme der Kühlkörperfassung einzusetzenden Metall-Kühlkörper zwischen der Kühlkörperfassung und der Leiterplatte dargestellt ist, wobei Wärmeleitungs-schichten zwischen der Kühlkörperfassung und der Leiterplatte einerseits und zwischen der Kühlkörperfassung und der Gehäusewand andererseits weggelassen sind;

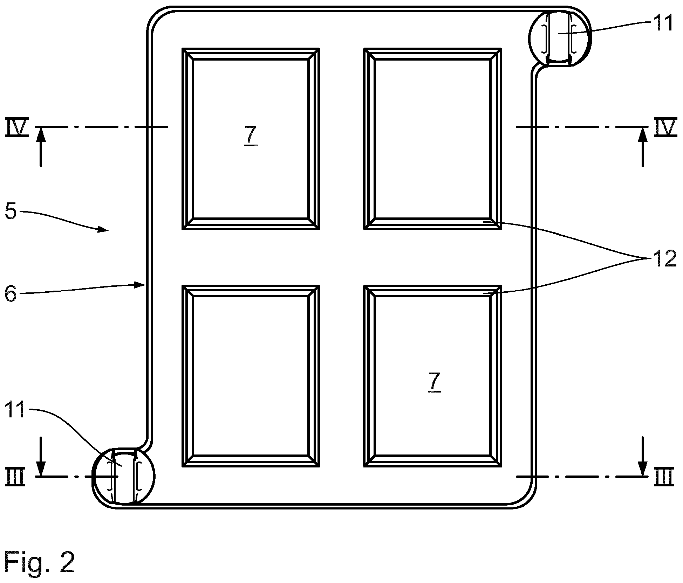

- Fig. 2: eine Aufsicht auf die Kunststoff-Kühlkörperfassung der Kühlvorrichtung nach Fig. 1;
- Fig. 3: einen Schnitt gemäß Linie III-III in Fig. 2;
- Fig. 4: einen Schnitt gemäß Linie IV-IV in Fig. 2; und
- Fig. 5: in einer zu Fig. 2 ähnlichen perspektivischen Darstellung mehrere Varianten von Kunststoff-Kühlkörper-fassungen, bestückbar mit zwei, vier oder sechs Me-tall-Kühlkörpern, nach Art der Kühlkörperfassung nach den Fig. 1 bis 4.

Fig. 1 zeigt in einer Explosionsdarstellung eine mit verschiedenen SMD-Bauelementen 1 bestückte Leiterplatte 2 und ein Metallgehäuse 3 zur Aufnahme der Leiterplatte 2. Zwischen der Leiterplatte 2 und einer bodenseitigen Gehäusewand 4 des Metallgehäuses 3 sind in der Fig. 1 Komponenten einer insgesamt mit 5 bezeichneten Kühlvorrichtung angeordnet. Die Kühlvorrichtung 5 dient zur Kühlung mindestens eines der Bauelemente 1, die auf der Leiterplatte 2 montiert sind. Die Kühlvorrichtung 5 hat als Wärmeleitelementfassung eine Kunststoff-Kühlkörperfassung 6 mit vier Kühlkörper-Aufnahmen 7 als Wärmeleitelement-Aufnahmen. Das Kunststoffmaterial der Kühlkörperfassung 6 ist brandfest, elektrisch isolierend, wärmebeständig und formbeständig.

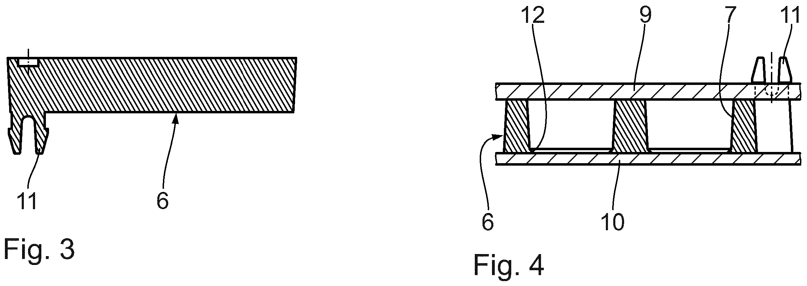

Die Kühlkörper-Aufnahmen 7 sind komplementär zu quaderförmigen Metall-Kühlkörpern 8 ausgeführt, von denen einer in der Fig. 1 dargestellt ist. Die Metall-Kühlkörper 8 dienen als Wärmeleitelemente. Die Metall-Kühlkörper 8 können aus Aluminium gefertigt sein. Die Kühlvorrichtung 5 wird zwischen der Leiterplatte 2 und der Gehäusewand 4 montiert. Nach Einbringung der Metall-Kühlkörper 8 in die jeweiligen Kühlkörper-Aufnahmen 7 der Kühlkörperfassung 6 wird auf die Kühlkörperfassung 6 eine in der Fig. 4 schematisch angedeutete, elektrisch isolierende Leiterplatten-Wärmeleitungsschicht 9 aufgebracht. Die Leiterplatten-Wärmeleitungsschicht 9 deckt die Kühlkörperfassung 6 bei montierter Kühlvorrichtung 5 zur Leiterplatte 2 hin ab. Die Leiterplatten-Wärmeleitungsschicht 9 steht mit dem Metall-Kühlkörper 8 einerseits und mit der Leiterplatte 2 in direkter wärmeleitender Verbindung. Die Leiterplatten-Wärmeleitungsschicht 9 ist aus elastischem Material. Die Leiterplatten-Wärmeleitungsschicht 9 steht über mindestens ein Via der Leiterplatte 2 mit dem zu kühlenden Bauteil 1 in wärmeleitender Verbindung.

Weiterhin weist die fertig montierte Kühlvorrichtung 5 eine Metallgehäuse-Wärmeleitungsschicht 10 auf, die die Kühlkörperfassung 6 bei montierter Kühlvorrichtung 5 zur Gehäusewand 4 des Metallgehäuses 3 hin abdeckt. Die Metallgehäuse-Wärmeleitungsschicht 10 steht einerseits mit dem Metall-Kühlkörper 8 und andererseits mit der Gehäusewand 4 in direkter wärmeleitender Verbindung. Die Metallgehäuse-Wärmeleitungsschicht 10 ist dicker als die Leiterplatten-Wärmeleitungsschicht 9 und beispielsweise doppelt so dick. Bei der Metallgehäuse-Wärmeleitungsschicht 10 kann es sich um eine Folie oder um eine gelartige Beschichtung handeln. Die Metallgehäuse-Wärmeleitungsschicht 10 kann zum Ausgleich von Höhentoleranzen ausgeführt sein.

Der Metall-Kühlkörper 8 kann aus Kupfer oder Aluminium gefertigt sein.

An die Kühlkörperfassung 6 einstückig angeformt sind zwei Verbindungselemente 11 zur mechanischen Verbindung der Kühlvorrichtung 5 mit der Leiterplatte 2. Die Verbindungselemente 11 sind jeweils als Schnapphaken ausgeführt, die in entsprechende Rastaufnahmen der Leiterplatte 2 eingerastet werden. Die beiden der Kühlkörperfassung 6 sind räumlich voneinander getrennt, nämlich an diagonal einander gegenüberliegenden Ecken der Kühlkörperfassung 6 angeformt.

Die Kühlkörperfassung 6 ist zur Aufnahme der vier Metall-Kühlkörper 8 nach Art eines 2x2-Rasters ausgeführt, weist also eine Gitter-Grundstruktur auf.

Die jeweilige Kühlkörper-Aufnahme 7 hat zur Metallgehäuse-Wärmeleitungsschicht 10 hin einen bodenseitigen, umlaufenden Vorsprung 12, der verhindert, dass der eingesetzte Metall-Kühlkörper 8 aus der Kühlkörper-Aufnahme 7 herausfällt.

Die Verbindungselemente 11 sind so ausgeführt, dass sie beim Montieren der Kühlvorrichtung 5 dieses führen und exakt positionieren. Eine Fehlmontage der Kühlvorrichtung 5 kann durch eine entsprechend komplementäre Anordnung der Verbindungselemente 11 einerseits und der zugehörigen Aufnahmen in der Leiterplatte 2 andererseits verhindert werden.

Die Kühlvorrichtung 5 wird folgendermaßen montiert: Zunächst werden in die Kühlkörperfassung 6 die Metall-Kühlkörper 8 in die zugeordneten Kühlkörper-Aufnahmen 7 eingeführt. Die Metall-Kühlkörper 8 können in den Kühlkörper-Aufnahmen 7 auch umspritzt sein. Anschließend werden die beiden Wärmeleitungsschichten 9, 10 aufgebracht. Die auf diese Weise komplettierte Kühlvorrichtung 5 wird dann an der vorgegebenen Position mit den Verbindungselementen 11 mit der Leiterplatte 2 verrastet. Anschließend wird das Metallgehäuse 3 mit der Leiterplatte 2 verschraubt. Diese Verschraubung kann unter Vorspannung erfolgen. Dies ist allerdings nicht zwingend.

Diese Montage der Kühlvorrichtung 5 kann teilweise oder vollständig automatisiert erfolgen.

Die Kühlvorrichtung 5 kann von der Leiterplatte 2 rückstandsfrei demontiert werden.

Die Kühlvorrichtung 5 mit den Metall-Kühlkörpern 8 und den Wärmeleitungsschichten 9, 10 kann separat und automatisiert vormontiert werden.

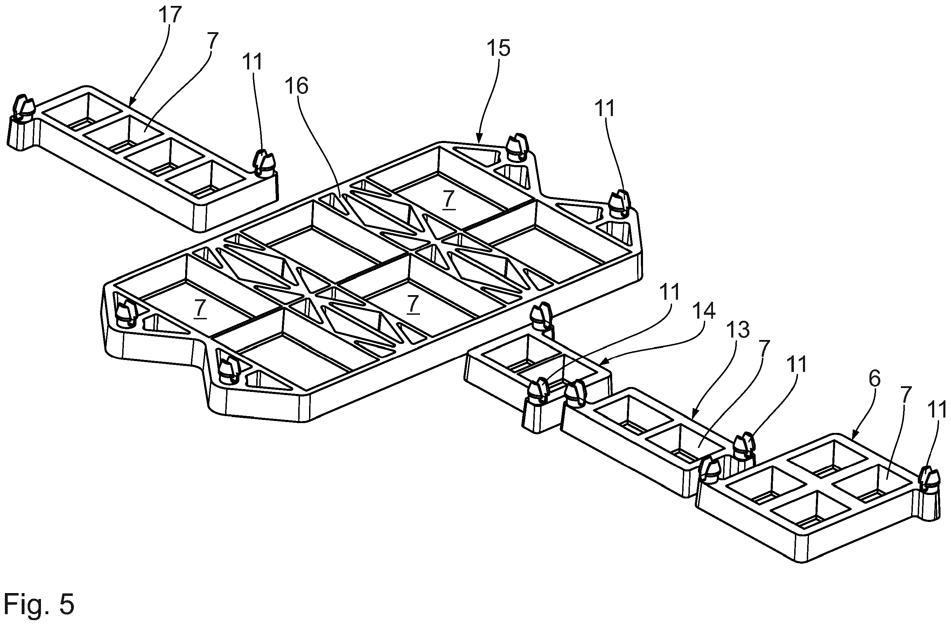

Fig. 5 zeigt verschiedene Ausführungen von Kühlvorrichtungen nach Art der Kühlvorrichtung 5.

Kühlfassungs-Varianten 13 und 14 sind zur Aufnahme von zwei Metall-Kühlkörpern 8 jeweils nach Art eines 2x1-Rasters ausgeführt, wobei bei der Kühlvorrichtung 13 die Kühlkörper-Aufnahmen 7 über Rechteck-Schmalseiten und bei der Kühlvorrichtung 14 über Rechteck-Breitseiten aneinander angrenzen.

Die Kühlfassungs-Variante 15 dient zur Aufnahme von insgesamt sechs Metall-Kühlkörpern 8, wobei die zugehörigen Kühlkörper-Aufnahmen 7 etwa sechsmal so groß sind wie die Kühlkörper-Aufnahmen der Fassungs-Varianten 6, 13 und 14. Jeweils über ihre Breitseite aneinander angrenzende Kühlkörper-Aufnahmen 7 der Fassungs-Variante 15 grenzen über eine Verstrebungsstruktur 16 der Kühlkörperfassung 15 aneinander an. Die Kühlkörperfassung 15 hat insgesamt vier Verbindungselemente 11.

Die Kühlkörperfassungs-Variante 17 ist ähnlich zur Kühlkörperfassungs-Variante 14 aufgebaut, dient allerdings zur Aufnahme von insgesamt vier Metall-Kühlkörpern 8 in einer 4x1-Rasteranordnung.

## Patentansprüche

1. Kühlvorrichtung (5) für mindestens ein auf einer Leiterplatte (2) montiertes Bauelement (1),
- mit mindestens einem Wärmeleitelement (8),
- mit einer Kunststoff-Wärmeleitelementfassung (6; 13; 14; 15; 17) mit mindestens einer Wärmeleitelement-Aufnahme (7),
- wobei das mindestens eine Wärmeleitelement (8) in der mindestens einen Wärmeleitelement-Aufnahme (7) angeordnet ist,
- mit einer Leiterplatten-Wärmeleitungsschicht (9), die die Wärmeleitelementfassung (6; 13; 14; 15; 17) bei montierter Kühlvorrichtung (5) zur Leiterplatte (2) hin abdeckt und mit dem Wärmeleitelement (8) in direkter wärmeleitender Verbindung steht,
- wobei die Kühlvorrichtung (5) derart ausgeführt ist, dass nach Einbringung des mindestens einen Wärmeleitelements (8) in die jeweilige Wärmeleitelement-Aufnahme (7) die Leiterplatten-Wärmeleitungsschicht (9) auf die Wärmeleitelementfassung aufgebracht wird.

2. Kühlvorrichtung nach Anspruch 1, **gekennzeichnet durch** mindestens ein Metallgehäuse (3) zur Aufnahme der Leiterplatte (2) und der Kühlvorrichtung (5), wobei die Kühlvorrichtung (5) zwischen der Leiterplatte (2) und einer Gehäusewand (4) des Metallgehäuses (3) angeordnet ist.

3. Kühlvorrichtung nach Anspruch 2, **gekennzeichnet durch** eine Metallgehäuse-Wärmeleitungsschicht (10), die die Kühlkörperfassung (6; 13; 14; 15; 17) bei montierter Kühlvorrichtung (5) zur Gehäusewand (4) des Metallgehäuses (3) hin abdeckt und mit dem Wärmeleitelement (8) in direkter wärmeleitender Verbindung steht.

4. Kühlvorrichtung nach einem der Ansprüche 1 bis 3, **gekennzeichnet durch** mindestens ein an die Wärmeleitelementfassung (6; 13; 14; 15; 17) angeformtes Verbindungselement (11) zur mechanischen Verbindung der Kühlvorrichtung (5) mit der Leiterplatte (2).

5. Kühlvorrichtung nach Anspruch 4, **dadurch gekennzeichnet, dass** das Verbindungselement (11) als Schnapphaken ausgeführt ist.

6. Kühlvorrichtung nach Anspruch 4 oder 5, **gekennzeichnet durch** mindestens zwei räumlich separierte Verbindungselemente (11), die an die Wärmeleitelementfassung (6; 13; 14; 15; 17) angeformt sind.

7. Mit Bauelementen bestückte Leiterplatte (2) mit mindestens einer Kühlvorrichtung (5) nach einem der Ansprüche 1 bis 6, **dadurch gekennzeichnet, dass** die Leiterplatten-Wärmeleitungsschicht (9) über mindestens ein Via der Leiterplatte (2) mit dem zu kühlenden Bauelement (1) in wärmeleitender Verbindung steht.

## Claims

1. Cooling device (5) for at least one component (1) mounted on a printed circuit board (2),
- comprising at least one heat conducting element (8),
- comprising a plastic heat conducting element frame (6; 13; 14; 15; 17) comprising at least one heat conducting element receptacle (7),
- wherein the at least one heat conducting element (8) is arranged in the at least one heat conducting element receptacle (7),
- comprising a printed circuit board heat conduction layer (9), which covers the heat conducting element frame (6; 13; 14; 15; 17), when the cooling device (5) is mounted, towards the printed circuit board (2) and which has a direct heat conductive link with the heat conducting element (8),
- wherein the cooling device (5) is designed such that after insertion of the at least one heat conducting element (8) into the respective heat conducting element receptacle (7), the printed circuit board heat conduction layer (9) is applied onto the heat conducting element receptacle.

2. Cooling device according to claim 1, **characterized by** at least one metal housing (3) for receiving the printed circuit board (2) and the cooling device (5), wherein the cooling device (5) is arranged between the printed circuit board (2) and a housing wall (4) of the metal housing (3).

3. Cooling device according to claim 2, **characterized by** a metal housing heat conduction layer (10), which covers the cooling body frame (6; 13; 14; 15; 17), when the cooling device (5) is mounted, towards the housing wall (4) of the metal housing (3) and has a direct heat-conductive link with the heat conducting element (8).

4. Cooling device according to any one of claims 1 to 3, **characterized by** at least one linking element (11) moulded on the heat conducting element frame (6; 13; 14; 15; 17) for mechanically linking the cooling device (5) to the printed circuit board (2).

5. Cooling device according to claim 4, **characterized in that** the linking element (11) is configured as a snap-fit.

6. Cooling device according to claim 4 or 5, **characterized by** at least two locally separated linking elements (11), which are moulded on the heat conducting element frame (6; 13; 14; 15; 17).

7. Printed circuit board (2) equipped with components, comprising at least one cooling device (5) according to any one of claims 1 to 6, **characterized in that** the printed circuit board heat conduction layer (9) has a heat conductive link with the component (1) to be cooled by at least one via of the printed circuit board (2).

## Revendications

1. Dispositif de refroidissement (5) pour au moins un composant (1) monté sur une carte de circuit imprimé (2),
- avec au moins un élément conducteur de chaleur (8),
- avec une monture d'élément conducteur de chaleur en matière plastique (6 ; 13 ; 14 ; 15 ; 17) avec au moins un logement d'élément conducteur de chaleur (7),
- dans lequel ledit au moins un élément conducteur de chaleur (8) est disposé dans ledit au moins un logement d'élément conducteur de chaleur (7),
- avec une couche de conduction thermique (9) de la carte de circuit imprimé, qui recouvre la monture d'élément conducteur de chaleur (6 ; 13 ; 14 ; 15 ; 17) en direction de la carte de circuit imprimé (2) lorsque le dispositif de refroidissement (5) est monté et qui est en liaison directe de conduction thermique avec l'élément conducteur de chaleur (8),
- dans lequel le dispositif de refroidissement (5) est réalisé de telle sorte qu'après l'introduction de l'au moins un élément conducteur de chaleur (8) dans le logement d'élément conducteur de chaleur (7) respectif, la couche de conduction thermique de carte de circuit imprimé (9) est appliquée sur la monture d'élément conducteur de chaleur.

2. Dispositif de refroidissement selon la revendication 1, **caractérisé par** au moins un boîtier métallique (3) destiné à recevoir la carte de circuit imprimé (2) et le dispositif de refroidissement (5), le dispositif de refroidissement (5) étant disposé entre la carte de circuit imprimé (2) et une paroi de boîtier (4) du boîtier métallique (3).

3. Dispositif de refroidissement selon la revendication 2, **caractérisé par** une couche de conduction thermique du boîtier métallique (10), qui recouvre la monture de corps de refroidissement (6 ; 13 ; 14 ; 15 ; 17) lorsque le dispositif de refroidissement (5) est monté, en direction de la paroi (4) du boîtier métallique (3) et qui est en liaison directe de conduction thermique avec l'élément conducteur de chaleur (8).

4. Dispositif de refroidissement selon l'une quelconque des revendications 1 à 3, **caractérisé par** au moins un élément de liaison (11) moulé sur la monture d'élément conducteur de chaleur (6 ; 13 ; 14 ; 15 ; 17) pour relier mécaniquement le dispositif de refroidissement (5) à la carte de circuit imprimé (2).

5. Dispositif de refroidissement selon la revendication 4, **caractérisé en ce que** l'élément de liaison (11) est réalisé sous forme de crochet à déclic.

6. Dispositif de refroidissement selon la revendication 4 ou 5, **caractérisé par** au moins deux éléments de liaison (11) séparés dans l'espace, qui sont moulés sur la monture d'élément conducteur de chaleur (6 ; 13 ; 14 ; 15 ; 17).

7. Carte de circuit imprimé (2) équipée de composants comprenant au moins un dispositif de refroidissement (5) selon l'une quelconque des revendications 1 à 6, **caractérisée en ce que** la couche de conduction thermique (9) de la carte de circuit imprimé est en liaison de conduction thermique avec le composant (1) à refroidir par au moins un via de la carte de circuit imprimé (2).
